# FASCICULE DE BREVET EUROPEEN

(11) **EP 3 111 736 B1**
(45) Date de publication et mention de la délivrance du brevet: **19.08.2020**
(21) Numéro de dépôt: 15709300.6
(22) Date de dépôt: 23.02.2015
(51) Int. Cl.: H05K 7/14, H01G 9/26, H02M 7/00

(54) **BLOC DE CAPACITÉS POUR UN MODULE ÉLECTRONIQUE DE PUISSANCE DE VÉHICULE AUTOMOBILE**
BANK VON KONDENSATOREN FÜR EIN ELEKTRONISCHES LEISTUNGSMODUL EINES KRAFTFAHRZEUGS
BANK OF CAPACITORS FOR AN AUTOMOTIVE VEHICLE ELECTRONIC POWER MODULE

(30) Priorité: 25.02.2014 FR 1451479
(43) Date de publication de la demande: 04.01.2017
(73) Titulaire: Valeo Equipements Electriques Moteur, 94046 Créteil Cedex (FR)
(72) Inventeur: DOMENGER, Laurent, F-91330 Yerres (FR); DUMEZ, Charles, F-75014 Paris (FR); CAVES, Laurent, F-94440 Marolles en Brie (FR)
(74) Mandataire: Mozelle, Gérard Jacques
(86) Numéro de dépôt international: PCT/FR2015/050430
(87) Numéro de publication internationale: WO 2015/128571

(56) Documents cités:
- WO-A1-2013/102720
- JP-A- 2009 044 920
- JP-A- 2009 111 435
- JP-A- 2013 027 284
- US-A1- 2012 300 521

## Description

### DOMAINE TECHNIQUE DE L'INVENTION.

La présente invention se rapporte à un bloc de capacités pour un module électronique de puissance de véhicule automobile.

### ARRIERE PLAN TECHNOLOGIQUE DE L'INVENTION.

Les véhicules automobiles à moteur thermique comportent classiquement un réseau électrique de bord comprenant une batterie, généralement de 12 V, destiné à alimenter en énergie électrique les divers équipements, notamment un démarreur, indispensable pour assurer le démarrage du moteur thermique. Après le démarrage, un alternateur accouplé au moteur thermique assure la charge de la batterie.

De nos jours, le développement de l'électronique de puissance permet de réaliser un bloc convertisseur de puissance alternatif/ continu réversible, c'est-à-dire fonctionnant soit en redresseur, soit en onduleur pour alimenter une seule machine électrique tournante polyphasée réversible qui remplace avantageusement le démarreur et l'alternateur.

Dans un premier temps, cette machine, connue sous le nom d'alterno-démarreur, avait essentiellement pour but de remplir les fonctions autrefois dédiées à l'alternateur et au démarreur, et, accessoirement, de récupérer l'énergie au freinage, ou d'apporter un supplément de puissance et de couple au moteur thermique.

Dans le but d'accroître la puissance et d'améliorer le rendement de l'alterno-démarreur en augmentant sa tension de fonctionnement tout en conservant la possibilité d'utiliser des autres équipements standards, prévus pour une alimentation de 12 V à 14 V, notamment les batteries au plomb, a été développée une architecture de réseau bitension.

Cette architecture consiste donc en un réseau électrique de puissance fonctionnant à une tension supérieure à 14 V, pouvant atteindre 48 V, auquel est relié l'alterno-démarreur et en un réseau électrique de service reliant tous les autres équipements. L'adaptation des niveaux de tensions entre les deux réseaux est assurée par un bloc convertisseur de puissance continu/ continu réversible.

Dans un second temps, des considérations écologiques, ont conduit à concevoir une architecture dite "mild-hybrid" en terminologie anglaise où des alterno-démarreurs ont une puissance, de l'ordre de 8 à 15 KW, suffisante pour entraîner le véhicule à faible vitesse, par exemple en environnement urbain.

De telles puissances posent de nouveaux problèmes au concepteur d'un convertisseur électronique qui comporte classiquement une carte de circuit imprimé sur laquelle sont montés des composants électroniques, notamment des circuits intégrés et des éléments discrets tels que des condensateurs. En effet, l'épaisseur des pistes du circuit imprimé étant faible, il est difficile d'utiliser un tel montage dans le cas d'applications nécessitant de forts courants, par exemple de l'ordre de plusieurs centaines d'ampères.

Dans la demande de brevet internationale WO2013102720, la société VALEO EQUIPEMENTS ELECTRIQUES MOTEUR propose des modes de réalisation d'un convertisseur courant continu - courant continu bidirectionnel et d'un onduleur réversible adaptés à une architecture "mild-hybrid" grâce à un assemblage original des condensateurs en un bloc de capacités compact au moyen de bus barres.

Le document JP 2009111435 décrit par ailleurs un bloc de capacités selon le préambule de la revendication 1.

Toutefois, les convertisseurs décrits ne sont pas explicitement des onduleurs réversibles aptes à être intégrés sur le palier arrière d'un alterno-démarreur, tels que le sont actuellement les onduleurs de moindre puissance.

Dans ce domaine d'application, l'onduleur doit satisfaire aux contraintes spécifiques d'un fonctionnement sous le capot moteur du véhicule automobile. Il doit, notamment:
- résister à une température élevée;
- résister aux fluides sous le capot;
- résister à une atmosphère corrosive;
- ne pas être sujet à la création de ponts salins entre les broches des condensateurs.

L'entité inventive a été confrontée à ces contraintes pour concevoir un bloc de capacités destiné à être connecté entre un réseau de puissance à 48 V et un onduleur réversible d'un alterno-démarreur de manière à assurer la stabilisation de la tension venant du réseau et la réduction des perturbations générées par les commutations des éléments de puissance.

Notamment, pour obtenir une réception des stations de radiodiffusion dans le véhicule, les niveaux de perturbations conduites ne doivent pas dépasser, en large bande aussi bien qu'en bande étroite, des valeurs limites définies par des normes.

Un filtrage différentiel de type LC est donc nécessaire pour réduire ces niveaux de perturbations

On connaît la mise en oeuvre d'inductances différentielles dans l'état de la technique, comme par exemple dans le convertisseur décrit dans la demande de brevet FR2961755 par la société VALEO SYSTEMES DE CONTRÔLE MOTEUR.

Une technologie utilisée pour réaliser l'inductance différentielle est appelée inductance bâton (« rod » en anglais), car elle est constituée d'un bobinage autour d'un matériau magnétique en forme de bâton magnétique. Le bobinage doit laisser passer le courant maximum de l'application sans s'échauffer de trop; il en résulte que le bobinage et le circuit magnétique présentent souvent un volume assez important.

Une autre technologie utilise un tore autour d'un bus barre pour concentrer les lignes de champ magnétique et ainsi créer une inductance de plus forte valeur.

Une difficulté de mise en oeuvre de cette solution réside dans l'association de ce tore avec le bloc de capacités, et dans les contraintes mécaniques exercées en cas d'ajout de résine en vue de bénéficier d'une meilleure dissipation thermique (le tore peut casser).

Ces solutions connues s'avèrent ne pas être compatibles avec l'application envisagée par l'entité inventive.

### DESCRIPTION GENERALE DE L'INVENTION.

La présente invention vise donc à pallier les inconvénients rappelés ci-dessus.

Elle concerne un bloc de capacités pour un module électronique de puissance de véhicule automobile du type de ceux comprenant une pluralité d'exemplaires d'un condensateur électrochimique agencés dans une cuve métallique au moyen d'un dispositif d'assemblage.

Cette cuve est munie extérieurement d'ailettes de refroidissement et remplie partiellement d'un matériau thermiquement conducteur et électriquement isolant.

Le dispositif d'assemblage comporte un bus barre de polarité positive et un bus barre de polarité négative maintenus l'un sur l'autre sans contact électrique au moyen d'un support isolant et destinés respectivement à être connectés électriquement à une borne positive et à une borne négative de ce module électronique de puissance.

Une plaque d'assemblage positive du bus barre de polarité positive comprend au moins un premier orifice de positionnement recevant une broche positive du condensateur électrochimique et une plaque d'assemblage négative du bus barre de polarité négative comprend au moins un second orifice de positionnement recevant une broche négative du condensateur électrochimique.

La plaque d'assemblage positive comprend également au moins un premier orifice de dégagement permettant à la broche négative de traverser la plaque d'assemblage positive sans contact électrique et la plaque d'assemblage négative comprend également au moins un second orifice de dégagement permettant à la broche positive de traverser sans contact la plaque d'assemblage négative.

Le bloc de capacités pour un module électronique de puissance de véhicule automobile selon l'invention est remarquable en ce qu'au moins un premier exemplaire du condensateur électrochimique constitue un condensateur différentiel d'un filtre différentiel de type LC intégré dans le bloc de capacités et apte à être connecté à un réseau de bord du véhicule automobile.

Ce filtre différentiel comprend avantageusement une inductance différentielle connectée d'une part à une première partie de la plaque d'assemblage positive et à une première partie correspondante de la plaque d'assemblage négative supportant le condensateur différentiel, et, d'autre part, apte à être connectée électriquement à la borne positive et à la borne négative du module électronique de puissance.

De préférence, cette inductance différentielle est constituée par le bus barre de polarité positive et par le bus barre de polarité négative.

Pour ce faire, la première partie de la plaque d'assemblage positive et la première partie correspondante de la plaque d'assemblage négative sont prolongées fort avantageusement, respectivement, par une première lame de liaison et par une seconde lame de liaison s'étendant au moins en partie en vis-à-vis sur une longueur prédéterminée, les première et seconde lames de liaison étant agencées de manière à être traversées par un courant circulant dans un même sens lorsque le bloc de capacités est sous tension.

La pluralité d'exemplaires du condensateur électrochimique est de préférence entourée au moins en partie par la première lame de liaison et/ ou la seconde lame de liaison.

Une au moins de la première lame de liaison et de la seconde lame de liaison est préférentiellement au moins en partie en forme de U.

Le bloc de capacités pour un module électronique de puissance de véhicule automobile selon l'invention est aussi remarquable en ce que des plaques de matériaux magnétiques sont agencées avantageusement à proximité de la première lame de liaison et/ ou de la seconde lame de liaison.

Ces plaques de matériaux magnétiques sont de préférence constituées de fer.

La première lame de liaison et la seconde lame de liaison sont aussi séparées par un isolant électrique. Dans cette forme de réalisation particulière, l'isolant électrique a une épaisseur sensiblement égale à 0,8 mm.

Le bloc de capacités pour un module électronique de puissance de véhicule automobile selon l'invention est de plus remarquable en ce que la première lame de liaison et la seconde lame de liaison sont chacune respectivement connectées électriquement à une seconde partie de la plaque d'assemblage positive et à une seconde partie correspondante de la plaque d'assemblage négative supportant au moins un second exemplaire du condensateur électrochimique constituant un condensateur réservoir apte à être connecté électriquement à la borne positive et à la borne négative du module électronique de puissance.

La première partie de la plaque d'assemblage positive, la première partie correspondante de la plaque d'assemblage négative, la seconde partie de la plaque d'assemblage positive, et la seconde partie correspondante de la plaque d'assemblage négative sont avantageusement munies respectivement de première, deuxième, troisième et quatrièmes languettes s'étendant perpendiculairement aux plaques d'assemblage positive et négative, la première lame de liaison étant connectée électriquement aux première et troisième languettes, et la seconde lame de liaison étant connectées électriquement aux deuxième et quatrième languettes.

L'invention concerne aussi un bloc de capacités pour un module électronique de puissance de véhicule automobile du type de ceux comprenant une pluralité de condensateurs, un bus barre de polarité positive et un bus barre de polarité négative maintenus l'un sur l'autre sans contact électrique au moyen d'un support isolant et destinés respectivement à être connectés électriquement à une borne positive et à une borne négative dudit module électronique de puissance, ledit bus barre de polarité positive et ledit bus barre de polarité négative comprenant respectivement une plaque d'assemblage positive avec les condensateurs et une plaque d'assemblage négative avec les condensateurs, caractérisé en ce qu'il comprend un filtre différentiel de type LC intégré dans ledit bloc de capacités et apte à être connecté à un réseau de bord dudit véhicule automobile.

Le bloc de capacités selon cette invention peut comprendre l'une quelconque des caractéristiques qui lui sont compatibles et qui ont été décrites précédemment.

Notamment, les condensateurs peuvent être des exemplaires d'un condensateur électrochimique.

Selon un mode de réalisation de ce bloc de capacités, au moins un premier condensateur constitue un condensateur différentiel du filtre différentiel intégré dans ledit bloc de capacités.

Selon un mode de réalisation de ce bloc de capacités, ledit filtre différentiel comprend une inductance différentielle intégrée audit bloc de capacité.

Selon un mode de réalisation de ce bloc de capacités, ladite inductance différentielle est constituée par ledit bus barre de polarité positive et par ledit bus barre de polarité négative.

Selon un mode de réalisation de ce bloc de capacités, ladite inductance différentielle est connectée d'une part à une première partie de ladite plaque d'assemblage positive et à une première partie correspondante de ladite plaque d'assemblage négative supportant ledit condensateur différentiel et, d'autre part, apte à être connectée électriquement à ladite borne positive et à ladite borne négative dudit module électronique de puissance.

Selon un mode de réalisation de ce bloc de capacités, ladite pluralité de condensateurs est entourée au moins en partie par ladite première lame de liaison et/ ou ladite seconde lame de liaison.

Selon un mode de réalisation de ce bloc de capacités, ladite première lame de liaison et ladite seconde lame de liaison sont chacune respectivement connectées électriquement à une seconde partie de ladite plaque d'assemblage positive isolée électriquement de ladite première partie et à une seconde partie correspondante de ladite plaque d'assemblage négative isolée électriquement de ladite première partie correspondante supportant au moins un second condensateur constituant un condensateur réservoir apte à être connecté électriquement à ladite borne positive et à ladite borne négative dudit module électronique de puissance.

Selon un mode de réalisation de ce bloc de capacités, les condensateurs sont agencés dans une cuve au moyen d'un dispositif d'assemblage comportant le bus barre de polarité positive et le bus barre de polarité négative. La cuve est notamment métallique.

Ces quelques spécifications essentielles auront rendu évidents pour l'homme de métier les avantages apportés par le bloc de capacités selon l'invention.

Les spécifications détaillées de l'invention sont données dans la description qui suit en liaison avec les dessins ci-annexés. Il est à noter que ces dessins n'ont d'autre but que d'illustrer le texte de la description et ne constituent en aucune sorte une limitation de la portée de l'invention.

### BREVE DESCRIPTION DES DESSINS.

La **Figure 1** est une vue éclatée en perspective d'un bloc de capacités pour un module électronique de puissance connu de l'état de la technique.
Les **Figures 2a** et **2b** sont des schémas de principe d'un bloc de capacités pour un module électronique de puissance de véhicule automobile selon l'invention.
La **Figure 3** est une vue générale en perspective d'un bloc de capacités pour un module électronique de puissance de véhicule automobile dans un mode de réalisation préféré de l'invention.
La **Figure 4** est une vue en perspective du bloc de capacités montré sur la **Figure 3****,** sans sa cuve, faisant apparaître les condensateurs.
La **Figure 5** est une vue en perspective des bus barres que comprend le bloc de capacités montré sur la **Figure 3****.**
La **Figure 6** est une vue en perspective des condensateurs montés sur les bus barres montrés sur la **Figure 5****.**
La **Figure 7** est une vue éclatée en perspective des condensateurs et des bus barres montrés sur la **Figure 6****.**

### DESCRIPTION DES MODES DE REALISATION PREFERES DE L'INVENTION.

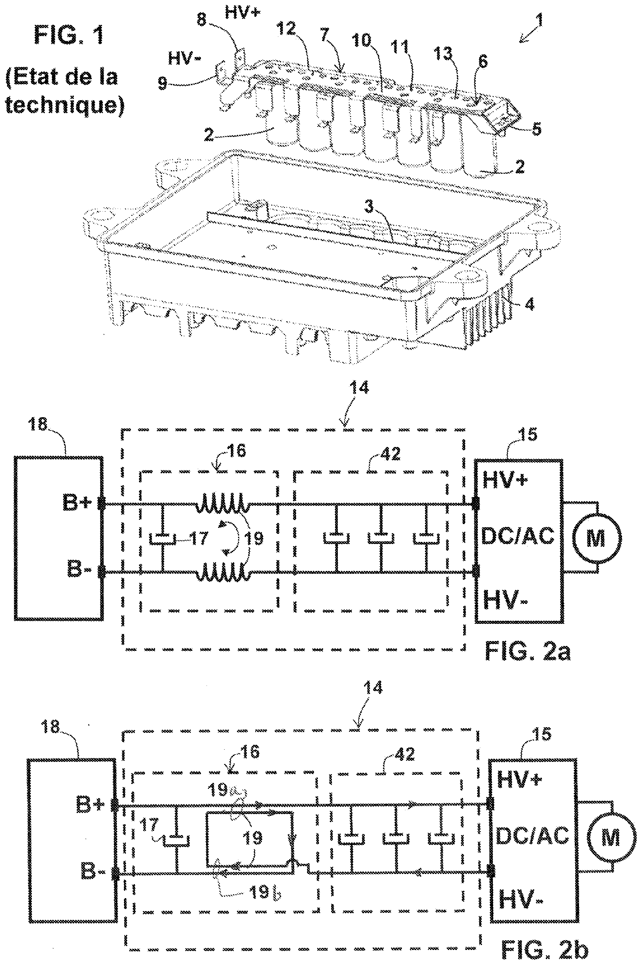

La **Figure 1** montre un bloc de capacités 1 pour un convertisseur électronique de puissance de véhicule automobile connu de l'état de la technique.

Il comprend une pluralité d'exemplaires d'un condensateur électrochimique 2 agencés dans une cuve métallique 3, munie extérieurement d'ailettes de refroidissement 4, partiellement remplie d'un matériau thermiquement conducteur et électriquement isolant.

Les condensateurs 2 sont assemblés au moyen d'un dispositif d'assemblage 5, 6, 7 qui comporte un bus barre de polarité positive 6 et un bus barre de polarité négative 7 maintenus l'un sur l'autre sans contact électrique au moyen d'un support isolant 5 et destinés respectivement à être connectés électriquement à une borne positive HV+ et à une borne négative HV- de ce convertisseur électronique de puissance au moyen d'une première patte positive 8 et d'une première patte négative 9.

Une plaque d'assemblage positive 10 du bus barre de polarité positive 6 comprend au moins un premier orifice de positionnement recevant une broche positive 11 du condensateur électrochimique et une plaque d'assemblage négative 12 du bus barre de polarité négative 7 comprend au moins un second orifice de positionnement recevant une broche négative du condensateur électrochimique 2.

La plaque d'assemblage positive 10 comprend également au moins un premier orifice de dégagement 13 permettant à la broche négative de traverser la plaque d'assemblage positive 10 sans contact électrique et la plaque d'assemblage négative 12 comprend également au moins un second orifice de dégagement permettant à la broche positive 11 de traverser sans contact la plaque d'assemblage négative 12.

Le bloc de capacités 14 pour module électronique de puissance 15 selon l'invention comprend un filtre différentiel 16 intégré dont le schéma de principe est donné sur les **Figures 2a** et **2b****.**

Ce filtre différentiel 16 est de type LC.

Il comporte un condensateur différentiel 17 apte à être connecté en parallèle au réseau de bord 18 du véhicule et une inductance différentielle 19 apte à être connectée à la borne positive HV+ et à la borne négative HV- de ce module de puissance 15.

Comme montré à la **Figure 2b****,** l'inductance différentielle 19 est obtenue au moyen d'une boucle de courant comportant des portions de circuits 19a, 19b avec des tronçons sensiblement parallèles dans lesquels les courants circulent dans le même sens de manière à favoriser l'effet inductif.

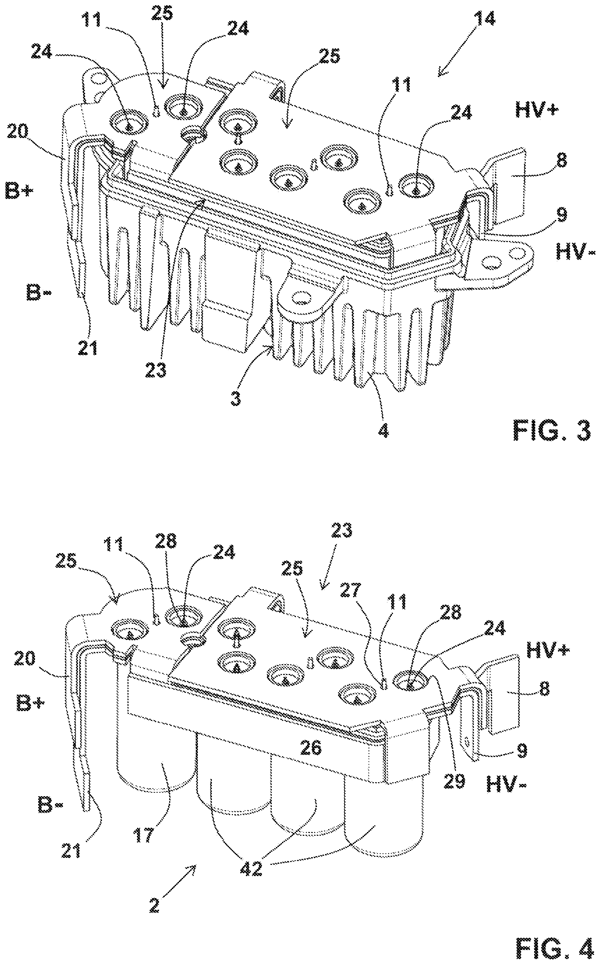

Dans un mode de réalisation préféré de l'invention, le bloc de capacités 14 se présente, de manière similaire au bloc de capacités connu 1, comme un bloc compact, de forme sensiblement parallélépipédique, présentant extérieurement des ailettes de refroidissement 4 et comportant une première patte positive 8 et une première patte négative 9 destinées à être reliées respectivement aux bornes positive HV+ et négative HV- du module de puissance associé 15, tel qu'un convertisseur alternatif - continu, ainsi que, comme le montre bien la **Figure 3****,** une seconde patte positive 20 et une seconde patte négative 21 destinées à recevoir des câbles de connexion B+, B- au réseau de puissance à 48 V.

Ce bloc de capacités 14 est essentiellement constitué de deux parties:
- un carter ou cuve 3 en aluminium moulé dans la paroi extérieure de laquelle sont formées les ailettes 4 de refroidissement;
- un couvercle 23 supportant une pluralité d'exemplaires d'un condensateur électrochimique 2, notamment quatre exemplaires.

Un condensateur électrochimique 2 se présente généralement sous la forme d'un corps cylindrique en aluminium muni de deux broches 11, 24, une broche positive 11 et une broche négative 24, soit axiales, s'étendant chacune à chaque extrémité du cylindre, soit situées toutes les deux sur une même extrémité.

Le condensateur électrochimique 2 utilisé dans ce mode de réalisation particulier de l'invention est de type "soldering star", et a typiquement une capacité nominale de plusieurs milliers de µFarad.

Ce condensateur 2 comporte une broche positive axiale 11 et deux broches négatives 24 (voire trois ou plus formant une étoile - d'où l'appellation) réunies par une couronne annulaire.

La broche positive 11 de chaque condensateur 2 est soudée au laser sur le bus barre de polarité positive 25, et les broches négatives 24 de chaque condensateur 2 sont soudées au laser sur le bus barre de polarité négative 26.

Les deux bus barres 25, 26 sont surmoulés l'un sur l'autre, sans contact électrique, dans la matière plastique du couvercle 23.

Comme le montre bien la **Figure 4****,** la broche positive 11 de chaque condensateur 2 est reçue dans un premier orifice de positionnement 27 du bus barre de polarité positive 25, et chacune des broches négatives 24 est reçue dans un second orifice de positionnement 28 du bus barre de polarité négative 26.

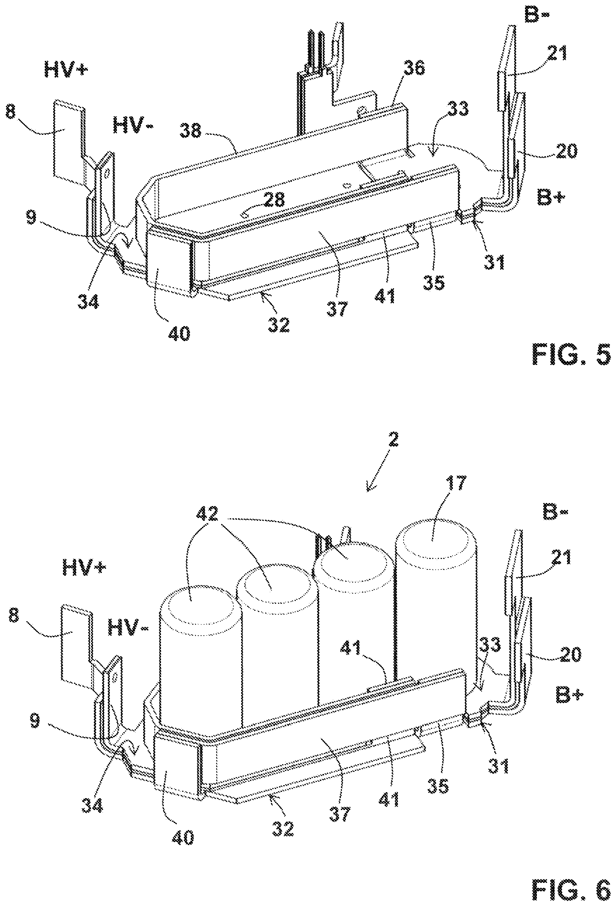

Les bus barres positif et négatif 25, 26 sont plus distinctement visibles sur les **Figures 5, 6****, et** **7****.**

Afin de permettre la soudure de chacune des broches négatives 24, le bus barre de polarité positive 25 comprend en regard de chacune de ces broches négatives 24 un premier orifice de dégagement 29 circulaire, de dimension suffisante pour éviter tout contact électrique.

Le bus barre de polarité négative 26 comprend également un second orifice de dégagement 30 autour de chaque broche positive 11 pour permettre à cette broche 11 de traverser le bus barre de polarité négative 26 sans contact électrique.

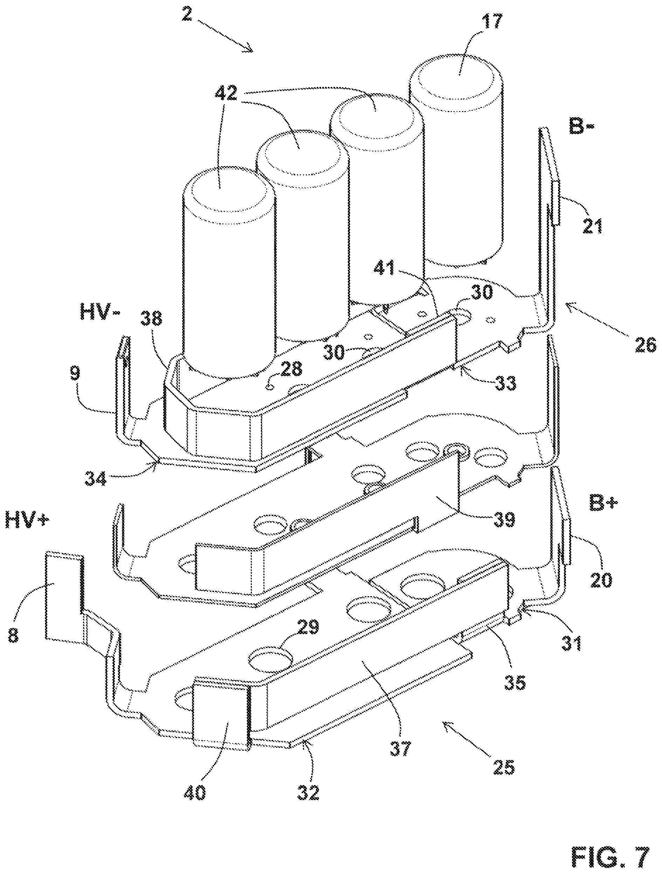

Afin d'intégrer le filtre différentiel 16, la vue éclatée de la **Figure 7** du bloc de capacités selon l'invention montre bien:
- une plaque d'assemblage positive 31, 32 du bus barre positif 25 comportant une première partie 31, et une plaque d'assemblage négative 33, 34 du bus barre négatif 26 comportant une première partie correspondante 33 supportant le condensateur différentiel 17;
- une première languette 35 s'étendant perpendiculairement à cette première partie 31 de la plaque d'assemblage positive 31, 32, et une deuxième languette 36, s'étendant perpendiculairement à la première partie correspondante 33 de la plaque d'assemblage négative 33, 34;
- une première lame de liaison 37 et une seconde lame de liaison 38 fixées chacune respectivement par une extrémité sur la première languette 35 et la deuxième languette 36 de manière à prolonger le bus barre positif 25 et le bus barre négatif 26.

Les première et seconde lames de liaison 37, 38 s'étendent en vis-à-vis à une distance constante l'une de l'autre prédéterminée, de l'ordre de 0,8 mm, de manière à constituer l'inductance différentielle 19 du filtre différentiel 16. Dans ces première et seconde lames de liaison 37, 38, les courants I circulent dans le même sens de manière à favoriser l'effet inductif, comme indiqué précédemment en référence à la Fig.2b (tronçon 19a) et comme montré par des flèches à la **Figure 2b****.**

Cet agencement est réalisé au moyen d'une pièce isolante 39, qui assure également l'isolement électrique des bus barres positif 25 et négatif 26 entre eux.

Les secondes pattes positive 20 et négative 21 permettent de relier le filtre différentiel 16 au réseau de puissance 18.

Les première et seconde lames de liaison 37, 38 sont connectées chacune par leurs autres extrémités respectivement à une troisième languette 40 portée par une seconde partie 32 de la plaque d'assemblage positive 31, 32, et à une quatrième languette 41 portée par une seconde partie correspondante 34 de la plaque d'assemblage négative 33, 34.

Cette seconde partie 32 de la plaque d'assemblage positive 31, 32 et la seconde partie correspondante 34 de la plaque d'assemblage négative 33, 34, isolées électriquement l'une de l'autre, portent trois condensateurs réservoirs 42 destinés à être reliés en parallèle aux bornes positive HV+ et négative HV- du module électronique de puissance 15 au moyen des premières pattes positive et négative 8, 9.

Comme le montrent bien les **Figures 5, 6****, et** **7****,** la seconde lame de liaison 38 est en forme de U. Elle entoure les trois condensateurs réservoirs 42.

Comme il va de soi l'invention ne se limite pas aux seuls modes d'exécution préférentiels décrits ci-dessus.

Une description analogue pourrait porter sur la fabrication d'un bloc de capacités 14 comportant un nombre d'exemplaires du condensateur électrochimique 2 différent de quatre, ce condensateur 2 comportant un nombre de broches positives et négatives 11, 24 différent de celui spécifié.

Le type de module électronique de puissance 15 n'est donné qu'à titre d'exemple. Il en est de même des valeurs numériques de la capacité nominale du condensateur 2 et de la tension du réseau de puissance B+, B-.

L'invention embrasse donc toutes les variantes possibles de réalisation dans la mesure où ces variantes restent dans le cadre défini par les revendications ci-après.

Dans un mode de réalisation, le bloc de capacités 14 comporte des plaques de matériau magnétique situées à proximité des premières 37 et seconde 38 lames de liaison pour améliorer les performances de filtrage du filtre différentiel 16, en particulier l'atténuation du bruit à des fréquences supérieures à 100kHz. A cet effet, les plaques sont notamment intégrées dans la cuve 3. Les plaques de matériau magnétique sont particulièrement avantageuses lorsque la cuve est en un matériau conducteur électrique qui s'oppose à l'effet inductif des bus barres 25, 26 dans un phénomène dit « effet plan ». Ces matériaux, par exemple l'aluminium, produisent un effet plan qui peut être renforcé si les condensateurs 17, 42 sont dans un matériau similaire, et donc avoir une influence non négligeable sur la valeur de l'inductance différentielle 19. Les plaques de matériau magnétique atténuent ces effets plans.

On entend par effet plan le phénomène dans lequel le conducteur (bus barre 25, 26) crée des lignes de champs qui vont interagir avec les plans de la cuve 3 ou des condensateurs 2, créant ainsi des courants induits qui viennent diminuer l'effet inductif recherché, c'est-à-dire la valeur de l'inductance différentielle 19.

Ces plaques de matériau magnétique peuvent être positionnées entre une lame de liaison 37, 38 et la cuve 3 et/ou entre une lame de liaison 37, 38 et un condensateur 2. Ces plaques de matériau magnétique peuvent être en fer. Elles peuvent être fixées à la cuve 3 ou au condensateur 2 par collage, résinage, ou tout autre moyen.

## Revendications

1. Bloc de capacités (14) pour un module électronique de puissance (15) de véhicule automobile du type de ceux comprenant une pluralité de condensateurs (17, 42), un bus barre de polarité positive (25) et un bus barre de polarité négative (26) maintenus l'un sur l'autre sans contact électrique au moyen d'un support isolant (39) et destinés respectivement à être connectés électriquement à une borne positive (HV+) et à une borne négative (HV-) dudit module électronique de puissance (15), ledit bus barre de polarité positive (25) et ledit bus barre de polarité négative (26) comprenant respectivement une plaque d'assemblage positive (31, 32) avec les condensateurs (17, 42) et une plaque d'assemblage négative (33, 34) avec les condensateurs (17, 42), **caractérisé en ce qu'**il comprend un filtre différentiel (16) de type LC intégré dans ledit bloc de capacités (14) et apte à être connecté à un réseau de bord (18) dudit véhicule automobile.

2. Bloc de capacités (14) pour un module électronique de puissance (15) de véhicule automobile selon la revendication 1, dans lequel au moins un premier condensateur (17) constitue un condensateur différentiel (17) du filtre différentiel (16) intégré dans ledit bloc de capacités (14).

3. Bloc de capacités (14) pour un module électronique de puissance (15) de véhicule automobile selon la revendication 1 ou 2, dans lequel ledit filtre différentiel (16) comprend une inductance différentielle (19) intégrée audit bloc de capacité (14).

4. Bloc de capacités (14) pour un module électronique de puissance (15) de véhicule automobile selon la revendication précédente, dans lequel ladite inductance différentielle (19) est constituée par ledit bus barre de polarité positive (25) et par ledit bus barre de polarité négative (26).

5. Bloc de capacités (14) pour un module électronique de puissance (15) de véhicule automobile selon la revendication 3 ou 4, dans lequel ladite inductance différentielle (19) est connectée d'une part à une première partie (31) de ladite plaque d'assemblage positive (31, 32) et à une première partie correspondante (33) de ladite plaque d'assemblage négative (33, 34) supportant ledit condensateur différentiel (17), et, d'autre part, apte à être connectée électriquement à ladite borne positive (HV+) et à ladite borne négative (HV-) dudit module électronique de puissance (15).

6. Bloc de capacités (14) pour un module électronique de puissance (15) de véhicule automobile selon la revendication précédente, dans lequel ladite première partie (31) de ladite plaque d'assemblage positive (31, 32) et ladite première partie correspondante (33) de ladite plaque d'assemblage négative (33, 34) sont prolongées respectivement par une première lame de liaison (37) et par une seconde lame de liaison (38) s'étendant au moins en partie en vis-à-vis sur une longueur prédéterminée, lesdites première et seconde lames de liaison (37, 38) étant agencées de manière à être traversées par un courant circulant dans un même sens lorsque le bloc de capacités est sous tension.

7. Bloc de capacités (14) pour un module électronique de puissance (15) de véhicule automobile selon la revendication précédente, dans lequel ladite pluralité de condensateurs (17, 42) est entourée au moins en partie par ladite première lame de liaison (37) et/ ou ladite seconde lame de liaison (38).

8. Bloc de capacités (14) pour un module électronique de puissance (15) de véhicule automobile selon la revendication précédente, dans lequel ladite première lame de liaison (37) et/ ou ladite seconde lame de liaison (38) est au moins en partie en forme de U.

9. Bloc de capacités (14) pour un module électronique de puissance (15) de véhicule automobile selon l'une quelconque des revendications 6 à 8, dans lequel des plaques de matériaux magnétiques sont agencées à proximité de ladite première lame de liaison (37) et/ ou de ladite seconde lame de liaison (38).

10. **Bloc** de capacités (14) pour un module électronique de puissance (15) de véhicule automobile selon la revendication précédente, dans lequel lesdites plaques de matériaux magnétiques sont constituées de fer.

11. Bloc de capacités (14) pour un module électronique de puissance (15) de véhicule automobile selon l'une quelconque des revendications 6 à 10, dans lequel ladite première lame de liaison (37) et ladite seconde lame de liaison (38) sont séparées par un isolant électrique (39).

12. Bloc de capacités (14) pour un module électronique de puissance (15) de véhicule automobile selon l'une quelconque des revendications 6 à 11 précédentes, dans lequel ladite première lame de liaison (37) et ladite seconde lame de liaison (38) sont chacune respectivement connectées électriquement à une seconde partie (32) de ladite plaque d'assemblage positive (31, 32) isolée électriquement de ladite première partie (31) et à une seconde partie correspondante (34) de ladite plaque d'assemblage négative (33, 34) isolée électriquement de ladite première partie correspondante (33) supportant au moins un second condensateur (42) constituant un condensateur réservoir (42) apte à être connecté électriquement à ladite borne positive (HV+) et à ladite borne négative (HV-) dudit module électronique de puissance (15).

13. Bloc de capacités (14) pour un module électronique de puissance (15) de véhicule automobile selon l'une quelconque des revendications 6 à 12, dans lequel ladite première partie (31) de ladite plaque d'assemblage positive (31, 32), ladite première partie correspondante (33) de ladite plaque d'assemblage négative (33, 34), ladite seconde partie (32) de ladite plaque d'assemblage positive (31, 32), et ladite seconde partie correspondante (34) de ladite plaque d'assemblage négative (33, 34) sont munies respectivement de première, deuxième, troisième et quatrièmes languettes (35, 36, 40, 41) s'étendant perpendiculairement auxdites plaques d'assemblage positive et négative (31, 32, 33, 34), ladite première lame de liaison (37) étant connectée électriquement auxdites première et troisième languettes (35, 40), et ladite seconde lame de liaison (38) étant connectées électriquement auxdites deuxième et quatrième languettes (36, 41).

14. Bloc de capacités (14) pour un module électronique de puissance (15) de véhicule automobile selon l'une quelconque des revendications précédentes, dans lequel les condensateurs sont agencés dans une cuve (3) au moyen d'un dispositif d'assemblage (25, 26, 39) comportant le bus barre de polarité positive (25) et le bus barre de polarité négative (26).

## Patentansprüche

1. Bank von Kondensatoren (14) für ein elektronisches Leistungsmodul (15) eines Kraftfahrzeugs von der Art, die Folgendes beinhaltet: eine Vielzahl von Kondensatorelementen (17, 42), eine Sammelschiene mit positiver Polarität (25) und eine Sammelschiene mit negativer Polarität (26), die mit Hilfe eines isolierenden Trägers (39) ohne elektrischen Kontakt übereinander gehalten werden und jeweils dazu bestimmt sind, mit einer positiven Klemme (HV+) und einer negativen Klemme (HV-) des elektronischen Leistungsmoduls (15) elektrisch verbunden zu sein, wobei die Sammelschiene mit positiver Polarität (25) und die Sammelschiene mit negativer Polarität (26) jeweils eine positive Verbindungsplatte (31, 32) mit den Kondensatorelementen (17, 42) und eine negative Verbindungsplatte (33, 34) mit den Kondensatorelementen (17, 42) beinhalten, **dadurch gekennzeichnet, dass** sie ein differentielles Filter (16) von der LC-Art beinhaltet, das in die Bank von Kondensatoren (14) integriert ist und fähig ist, mit einem Bordnetz (18) des Kraftfahrzeugs verbunden zu sein.

2. Bank von Kondensatoren (14) für ein elektronisches Leistungsmodul (15) eines Kraftfahrzeugs nach Anspruch 1, wobei mindestens ein erstes Kondensatorelement (17) ein differentielles Kondensatorelement (17) des differentiellen Filters (16), das in die Bank von Kondensatoren (14) integriert ist, bildet.

3. Bank von Kondensatoren (14) für ein elektronisches Leistungsmodul (15) eines Kraftfahrzeugs nach Anspruch 1 oder 2, wobei das differentielle Filter (16) eine differentielle Induktivität (19), die in die Bank von Kondensatoren (14) integriert ist, beinhaltet.

4. Bank von Kondensatoren (14) für ein elektronisches Leistungsmodul (15) eines Kraftfahrzeugs nach dem vorhergehenden Anspruch, wobei die differentielle Induktivität (19) durch die Sammelschiene mit positiver Polarität (25) und durch die Sammelschiene mit negativer Polarität (26) gebildet ist.

5. Bank von Kondensatoren (14) für ein elektronisches Leistungsmodul (15) eines Kraftfahrzeugs nach Anspruch 3 oder 4, wobei die differentielle Induktivität (19) einerseits mit einem ersten Teil (31) der positiven Verbindungsplatte (31, 32) und mit einem entsprechenden ersten Teil (33) der negativen Verbindungsplatte (33, 34), die das differentielle Kondensatorelement (17) tragen, verbunden ist und andererseits fähig ist, mit der positiven Klemme (HV+) und der negativen Klemme (HV-) des elektronischen Leistungsmoduls (15) elektrisch verbunden zu sein.

6. Bank von Kondensatoren (14) für ein elektronisches Leistungsmodul (15) eines Kraftfahrzeugs nach dem vorhergehenden Anspruch, wobei der erste Teil (31) der positiven Verbindungsplatte (31, 32) und der entsprechende erste Teil (33) der negativen Verbindungsplatte (33, 34) jeweils durch ein erstes Anschlussblech (37) und durch ein zweiten Anschlussblech (38) verlängert werden, die sich über eine vorgegebene Länge mindestens teilweise gegenüberliegend erstrecken, wobei das erste und das zweite Anschlussblech (37, 38) so angeordnet sind, dass sie von einem Strom, der in einer gleichen Richtung fließt, durchquert werden, wenn die Bank von Kondensatoren unter Spannung steht.

7. Bank von Kondensatoren (14) für ein elektronisches Leistungsmodul (15) eines Kraftfahrzeugs nach dem vorhergehenden Anspruch, wobei die Vielzahl von Kondensatorelementen (17, 42) mindestens teilweise von dem ersten Anschlussblech (37) und/oder dem zweiten Anschlussblech (38) umgeben ist.

8. Bank von Kondensatoren (14) für ein elektronisches Leistungsmodul (15) eines Kraftfahrzeugs nach dem vorhergehenden Anspruch, wobei das erste Anschlussblech (37) und/oder das zweite Anschlussblech (38) mindestens teilweise eine U-Form aufweisen.

9. Bank von Kondensatoren (14) für ein elektronisches Leistungsmodul (15) eines Kraftfahrzeugs nach einem der Ansprüche 6 bis 8, wobei Platten aus magnetischen Materialien in der Nähe des ersten Anschlussblechs (37) und/oder des zweiten Anschlussblechs (38) angeordnet sind.

10. Bank von Kondensatoren (14) für ein elektronisches Leistungsmodul (15) eines Kraftfahrzeugs nach dem vorhergehenden Anspruch, wobei die Platten aus magnetischen Materialien aus Eisen gebildet sind.

11. Bank von Kondensatoren (14) für ein elektronisches Leistungsmodul (15) eines Kraftfahrzeugs nach einem der Ansprüche 6 bis 10, wobei das erste Anschlussblech (37) und das zweite Anschlussblech (38) durch einen elektrischen Isolator (39) getrennt sind.

12. Bank von Kondensatoren (14) für ein elektronisches Leistungsmodul (15) eines Kraftfahrzeugs nach einem der vorhergehenden Ansprüche 6 bis 11, wobei das erste Anschlussblech (37) und das zweite Anschlussblech (38) jeweils mit einem zweiten Teil (32) der positiven Verbindungsplatte (31, 32), der von dem ersten Teil (31) elektrisch isoliert ist, bzw. mit einem entsprechenden zweiten Teil (34) der negativen Verbindungsplatte (33, 34), der von dem entsprechenden ersten Teil (33) elektrisch isoliert ist, elektrisch verbunden sind, die mindestens ein zweites Kondensatorelement (42) tragen, das ein Speicherkondensatorelement (42) bildet, das fähig ist, mit der positiven Klemme (HV+) und der negativen Klemme (HV-) des elektronischen Leistungsmoduls (15) elektrisch verbunden zu sein.

13. Bank von Kondensatoren (14) für ein elektronisches Leistungsmodul (15) eines Kraftfahrzeugs nach einem der Ansprüche 6 bis 12, wobei der erste Teil (31) der positiven Verbindungsplatte (31, 32), der entsprechende erste Teil (33) der negativen Verbindungsplatte (33, 34), der zweite Teil (32) der positiven Verbindungsplatte (31, 32) und der entsprechende zweite Teil (34) der negativen Verbindungsplatte (33, 34) jeweils mit einer ersten, zweiten, dritten und vierten Lasche (35, 36, 40, 41) versehen sind, die sich senkrecht zu der positiven und negativen Verbindungsplatte (31, 32, 33, 34) erstrecken, wobei das erste Anschlussblech (37) mit der ersten und dritten Lasche (35, 40) elektrisch verbunden ist und das zweite Anschlussblech (38) mit der zweiten und vierten Lasche (36, 41) elektrisch verbunden ist.

14. Bank von Kondensatoren (14) für ein elektronisches Leistungsmodul (15) eines Kraftfahrzeugs nach einem der vorhergehenden Ansprüche, wobei die Kondensatorelemente mit Hilfe einer Verbindungsvorrichtung (25, 26, 39), die die Sammelschiene mit positiver Polarität (25) und die Sammelschiene mit negativer Polarität (26) umfasst, in einem Behälter (3) angeordnet sind.

## Claims

1. Capacitor pack (14) for a motor-vehicle power electronic module (15) of the type comprising a plurality of capacitors (17, 42), a busbar of positive polarity (25) and a busbar of negative polarity (26) which are held together without electrical contact by means of an insulating holder (39) and are intended to be electrically connected to a positive terminal (HV+) and to a negative terminal (HV-), respectively, of said power electronic module (15), said busbar of positive polarity (25) and said busbar of negative polarity (26) comprising, respectively, a positive plate (31, 32) for assembly with the capacitors (17, 42) and a negative plate (33, 34) for assembly with the capacitors (17, 42), **characterized in that** it comprises an LC differential filter (16) which is incorporated within said capacitor pack (14) and is capable of being connected to an onboard network (18) of said motor vehicle.

2. Capacitor pack (14) for a motor-vehicle power electronic module (15) according to Claim 1, wherein at least one first capacitor (17) constitutes a differential capacitor (17) of the differential filter (16) incorporated within said capacitor pack (14) .

3. Capacitor pack (14) for a motor-vehicle power electronic module (15) according to Claim 1 or 2, wherein said differential filter (16) comprises a differential inductor (19) incorporated within said capacitor pack (14).

4. Capacitor pack (14) for a motor-vehicle power electronic module (15) according to the preceding claim, wherein said differential inductor (19) consists of said busbar of positive polarity (25) and of said busbar of negative polarity (26).

5. Capacitor pack (14) for a motor-vehicle power electronic module according to Claim 3 or 4, wherein said differential inductor (19) both is connected to a first portion (31) of said positive assembly plate (31, 32) and to a corresponding first portion (33) of said negative assembly plate (33, 34) holding said differential capacitor (17), and is capable of being electrically connected to said positive terminal (HV+) and to said negative terminal (HV-) of said power electronic module (15).

6. Capacitor pack (14) for a motor-vehicle power electronic module (15) according to the preceding claim, wherein said first portion (31) of said positive assembly plate (31, 32) and said corresponding first portion (33) of said negative assembly plate (33, 34) are extended by a first connecting strip (37) and by a second connecting strip (38), respectively, which run at least partly facing one another along a predetermined length, said first and second connecting strips (37, 38) being arranged so as to carry a current that flows in the same direction when the capacitor pack is being supplied with power.

7. Capacitor pack (14) for a motor-vehicle power electronic module (15) according to the preceding claim, wherein said plurality of capacitors (17, 42) is at least partly surrounded by said first connecting strip (37) and/or said second connecting strip (38).

8. Capacitor pack (14) for a motor-vehicle power electronic module (15) according to the preceding claim, wherein said first connecting strip (37) and/or said second connecting strip (38) is at least partly U-shaped.

9. Capacitor pack (14) for a motor-vehicle power electronic module (15) according to any one of Claims 6 to 8, wherein plates of magnetic materials are arranged in proximity to said first connecting strip (37) and/or to said second connecting strip (38) .

10. Capacitor pack (14) for a motor-vehicle power electronic module (15) according to the preceding claim, wherein said plates of magnetic materials are made of iron.

11. Capacitor pack (14) for a motor-vehicle power electronic module (15) according to any one of Claims 6 to 10, wherein said first connecting strip (37) and said second connecting strip (38) are separated by an electrical insulator (39).

12. Capacitor pack (14) for a motor-vehicle power electronic module (15) according to any one of the preceding Claims 6 to 11, wherein said first connecting strip (37) and said second connecting strip (38) are each electrically connected, respectively, to a second portion (32) of said positive assembly plate (31, 32), which is electrically insulated from said first portion (31), and to a corresponding second portion (34) of said negative assembly plate (33, 34), which is electrically insulated from said corresponding first portion (33) which holds at least one second capacitor (42) constituting a reservoir capacitor (42) that is capable of being electrically connected to said positive terminal (HV+) and to said negative terminal (HV-) of said power electronic module (15).

13. Capacitor pack (14) for a motor-vehicle power electronic module (15) according to any one of Claims 6 to 12, wherein said first portion (31) of said positive assembly plate (31, 32), said corresponding first portion (33) of said negative assembly plate (33, 34), said second portion (32) of said positive assembly plate (31, 32) and said corresponding second portion (34) of said negative assembly plate (33, 34) are provided with first, second, third and fourth tabs (35, 36, 40, 41), respectively, which run perpendicular to said positive and negative assembly plates (31, 32, 33, 34), said first connecting strip (37) being electrically connected to said first and third tabs (35, 40) and said second connecting strip (38) being electrically connected to said second and fourth tabs (36, 41) .

14. Capacitor pack (14) for a motor-vehicle power electronic module (15) according to any one of the preceding claims, wherein the capacitors are arranged within a container (3) by means of an assembly device (25, 26, 39) including the busbar of positive polarity (25) and the busbar of negative polarity (26).
